# EUROPEAN PATENT APPLICATION

(11) **EP 4 092 157 A1**
(43) Date of publication of application: **23.11.2022**
(21) Application number: 21740992.9
(22) Date of filing: 12.01.2021
(51) Int. Cl.: C23C 18/34, C23C 18/44, C23C 18/52

(54) **ELECTROLESS PLATING PROCESS AND TWO-LAYER PLATING FILM**

(30) Priority: 14.01.2020 JP 2020003416
(71) Applicant: Kojima Chemicals Co. Ltd., Sayama-shi, Saitama 350-1335 (JP)
(72) Inventor: WATANABE, Hideto, Sayama-shi, Saitama 350-1335 (JP); KATO, Tomohito, Sayama-shi, Saitama 350-1335 (JP)
(74) Representative: Vossius & Partner Patentanwälte Rechtsanwälte mbB
(86) International application number: PCT/JP2021/000623
(87) International publication number: WO 2021/145300

(57) **Abstract**

An object is to provide a electroless plating process that enables reduction in production costs and a two-layer plating film obtained by the process. For the purpose of achieving this object, adopted is a electroless plating process for forming a nickel plating film and a gold plating film in this order on a surface of a copper material by a electroless plating method, the electroless plating process comprising: a step of forming a nickel plating film containing boron by a reductive electroless nickel strike plating method, and a step of forming a gold plating film by a reductive electroless gold plating method. The two-layer plating film according to the present invention is formed by this process.

## Description

### Technical Field

The present invention relates to a electroless plating process for producing a gold plating film on a surface of a copper material by a electroless plating method, and a two-layer plating film.

### Background Art

In order to address the needs for higher performance and multi-function in electronic devices, downsizing of electronic components to be mounted are proceeding. Then, there is a need for mounting the electronic components at higher densities on a printed wiring board, such as a resin substrate or a ceramic substrate. Accordingly, fining of wiring patterns on printed wiring boards are proceeding, and high level techniques for mounting the electronic components are needed with the fining of wiring patterns. Generally, as the techniques for mounting electronic components or terminal components on printed wiring boards, mounting techniques involving solder or wire bonding have been established.

For the purpose of ensuring the reliability of mounting components on a wiring pattern on a printed wiring board when mounting, a plating treatment as a surface treatment is carried out on a wiring pad for mounting a component, which is a part of a wiring pattern on a printed wiring board. For the plating treatment, there is a technique involving providing a palladium catalyst on a wiring pattern formed of copper, which has a small electrical resistance, and then performing nickel plating and displacement gold plating sequentially. There is also a technique involving providing a palladium catalyst and then performing nickel plating, palladium plating, and gold plating sequentially. This nickel plating film is for preventing corrosion of copper wiring by solder. The palladium plating film is for preventing diffusion of nickel that forms the nickel plating film to the gold plating film. The gold plating film is provided for obtaining good wettability with solder while achieving a small electrical resistance.

As an example of such a plating technique, Patent Literature 1 discloses a plating method including the steps of degreasing, etching, providing a palladium catalyst, electroless nickel plating, electroless palladium plating, and electroless gold plating, for example.

### Citation List

### Patent Literature

Patent Literature 1: Japanese Patent Laid-Open No. 2008-174774

### Summary of Invention

### Technical Problem

In the plating method disclosed in Patent Literature 1, however, a palladium catalyst is provided before the formation of the electroless nickel plating film. Generally, providing a palladium catalyst is a necessary step for forming a electroless nickel plating film on the surface of a copper material. On the other hand, the palladium catalyst not only effects deposition of nickel on the surface of the copper material, but also has the following problem: the palladium catalyst is likely to remain on an insulated region between wiring patterns, and nickel is deposited in a gap between wiring patterns. Such a phenomenon tends to unfortunately cause failure in favorable plating on a fine wiring pattern.

It is also considered that in the plating method disclosed in Patent Literature 1, the palladium plating film prevents local corrosion of nickel when plating with gold to thereby ensure the wire bonding property. However, such a method causes the problem of resulting in high production costs.

Accordingly, an object of the present invention is to provide a electroless plating process that enables plating a fine wiring pattern and also enables reduction in production costs when obtaining a plating film having the excellent various mounting properties with solder and the excellent wire bonding property.

### Solution to Problem

The electroless plating process according to the present invention is a electroless plating process for producing a nickel plating film and a gold plating film in this order on a surface of a copper material by a electroless plating method, the electroless plating process being characterized by comprising a step of producing a nickel plating film containing boron by a reductive electroless nickel strike plating method, and a step of producing a gold plating film by a reductive electroless gold plating method.

The two-layer plating film according to the present invention is characterized in that it is a two-layer plating film produced by the above-described electroless plating process, and consists of a nickel plating film containing boron and a gold plating film.

### Advantageous Effects of Invention

The electroless plating process according to the present invention is a electroless plating process for producing a nickel plating film and a gold plating film in this order on a surface of a copper material by a electroless plating method, the electroless plating process comprising: a step of producing a nickel plating film containing boron by a reductive electroless nickel strike plating method, and a step of producing a gold plating film by a reductive electroless gold plating method. Specifically, the electroless plating process according to the present invention enables production of a nickel plating film directly on the surface of a copper material without providing any palladium catalyst, and thus enables plating a fine wiring pattern. In addition, the electroless plating process according to the present invention enables production of a gold plating film on the surface of the nickel plating film by the reductive electroless gold plating method while preventing local corrosion of nickel without providing any palladium plating film, and thus enables production of plating films at a reduced cost.

The two-layer plating film according to the present invention is a two-layer plating film consisting of a nickel plating film containing boron and a gold plating film. Since the two-layer plating film includes boron in the nickel plating film, diffusion of copper to the gold plating film is suppressed, and the two-layer plating film thus has the excellent various mounting properties with solder and the excellent wire bonding property without thickening the film thickness of the gold plating film.

### Brief Description of Drawings

[Figure 1] Figure 1 is a flowchart showing a electroless plating process of the present embodiment.
[Figure 2] Figure 2 is a schematic cross-sectional view of a two-layer plating film of the present embodiment.
[Figure 3] Figure 3 shows images of the cross-section of the interface moiety between the nickel plating film and the gold plating film in Example and Comparative Example 2.
[Figure 4] Figure 4 shows the measurement results of the shear strength of solder ball in Example and Comparative Examples 1 and 2.
[Figure 5] Figure 5 shows the confirmation results of the breaking mode of the solder balls in the measurement of the shear strength of solder ball in Example and Comparative Examples 1 and 2.
[Figure 6] Figure 6 shows the measurement results of the pull strength of the bonding wire in Example and Comparative Examples 2 to 4.

### Description of Embodiments

### 1. Embodiment of electroless plating process according to present invention

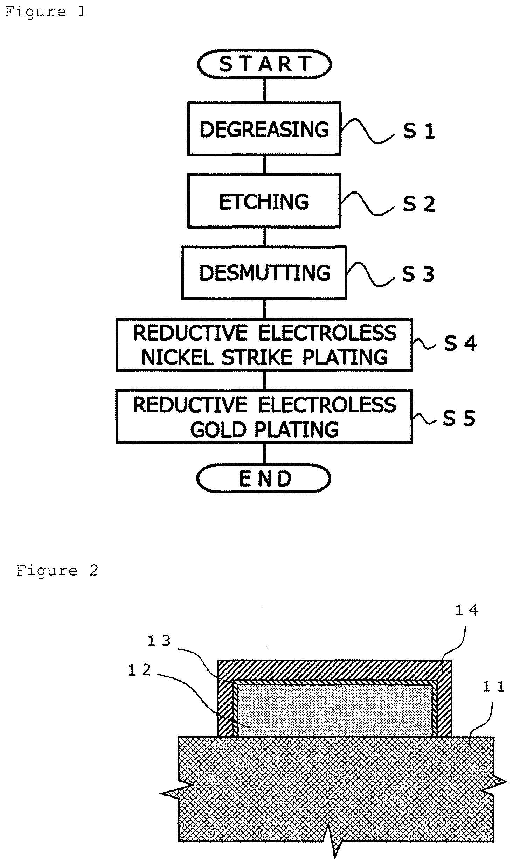

Embodiments of the electroless plating process according to the present invention will be described below. The electroless plating process of the present embodiment is a electroless plating process for producing a nickel plating film 13 and a gold plating film 14 in this order on the surface of copper wiring 12 provided on the surface of a substrate 11 by a electroless plating method as shown in Figure 2.

Specifically, the electroless plating process of the present embodiment is a electroless plating process for forming a two-layer plating film according to the present invention, the electroless plating process including a step of producing a nickel plating film on the surface of a copper material by a reductive electroless nickel strike plating method without use of any palladium catalyst, and a step of producing a gold plating film by a reductive electroless gold plating method. In the present embodiment, described is a process for forming the two-layer plating film according to the present invention by producing a nickel plating film 13 and a gold plating film 14 in this order on the surface of a copper material.

A flowchart of the electroless plating process of the present embodiment is shown in Figure 1. As shown in Figure 1, the degreasing step (S1), the etching step (S2), and the desmutting step (S3) are firstly carried out as pretreatments before producing a nickel plating film. Thereafter, a nickel plating film 13 is produced on the surface of a copper material by the reductive electroless nickel strike plating step (S4). Subsequently, a gold plating film 14 is produced by the reductive electroless gold plating step (S5). After each of these steps, washing treatment with water is carried out. The washing treatment with water is preferably carried out three times.

### 1-1. Degreasing step (S1) in embodiment

In the degreasing step (S1), the copper material is immersed in an acid solution to thereby remove contaminants, oil/fat, and others adhered to the surface of the copper material.

### 1-2. Etching step (S2) in embodiment

In the etching step (S2), the copper material that has undergone the degreasing step (S1) is immersed in a persulfuric acid-based, hydrogen peroxide-based, thiol-based, or other etching liquid to thereby remove an unnecessary copper oxide film formed on the surface of the copper material.

### 1-3. Desmutting step (S3) in embodiment

In the desmutting step (S3), the copper material that has undergone the etching step (S2) is immersed in, for example, 10% sulfuric acid to thereby remove smut adhered to the surface of the copper material (components remaining on and adhered to the surface in the etching step).

### 1-4. Reductive electroless nickel strike plating step (S4) in embodiment

In the reductive electroless nickel strike plating step (S4), a reductive electroless nickel strike plating solution is used that includes 0.002 g/L or more and 1 g/L or less, in terms of nickel, of a water-soluble nickel salt, a carboxylic acid or a salt thereof, and "one or more reducing agents selected from the group consisting of dimethylamine borane, trimethylamine borane, and sodium borohydride" and has a pH prepared to 6.0 or more and 10 or less and a bath temperature prepared to 20°C or more and 55°C or less. In the reductive electroless nickel strike plating method in the present invention, the copper material that has undergone the desmutting step (S3) is immersed in such a reductive electroless nickel strike plating solution to thereby producing the nickel plating film 13 on the surface of the copper material.

### 1-4-1. Reductive electroless nickel strike plating solution

The reductive electroless nickel strike plating solution used is prepared by mixing a water-soluble nickel salt, a carboxylic acid or a salt thereof, and water and stirring the resultant to thereby prepare an aqueous solution including a nickel complex, and then mixing a reducing agent with the aqueous solution and stirring the resultant. The reducing agent is one or more selected from the group consisting of dimethylamine borane, trimethylamine borane, and sodium borohydride. Since the reductive electroless nickel strike plating solution includes one or more selected from the group consisting of dimethylamine borane, trimethylamine borane as the reducing agent, and sodium borohydride, the nickel plating film to be produced contains boron.

### Water-soluble nickel salt

Examples of the water-soluble nickel salt used for the reductive electroless nickel strike plating solution include nickel sulfate, nickel chloride, nickel carbonate, and a nickel organic acid such as nickel acetate, nickel hypophosphite, nickel sulfamate, and nickel citrate. These may be used singly or may be used in combinations of two or more thereof. In the present invention, it is most preferable to use nickel sulphate hexahydrate as the water-soluble nickel salt.

The content of the water-soluble nickel salt contained in the reductive electroless nickel strike plating solution is preferably 0.002 g/L or more and 1 g/L or less, in terms of nickel. When the reductive electroless nickel strike plating solution has a water-soluble nickel salt content (in terms of nickel) within the above-described range, the electroless nickel strike plating method can be achieved to produce a nickel plating film directly on the surface of the copper material without providing any palladium catalyst.

If the water-soluble nickel salt content (in terms of nickel) is less than 0.002 g/L, the deposition rate is so low that a long immersing time is necessary for obtaining a nickel plating film having a desired film thickness, and thus the sufficient industrial productivity cannot be obtained, which is not preferable. On the other hand, if the water-soluble nickel salt content (in terms of nickel) is more than 1 g/L, the deposition rate is so high that a nickel plating film 13 having a smooth surface may not be obtained, which is not preferable. The water-soluble nickel salt content (in terms of nickel) is more preferably 0.01 g/L or more and 0.5 g/L or less in view of the deposition rate of nickel, and most preferably 0.03 g/L or more and 0.1 g/L or less in view of the deposition rate of nickel and also stably obtaining a smooth surface of the deposit.

### Carboxylic acid or salt thereof:

The reductive electroless nickel strike plating solution includes a carboxylic acid or a salt thereof. These are each a complexing agent and also functions as a pH adjuster. The carboxylic acid used may be, for example, one or more selected from a monocarboxylic acid (formic acid, acetic acid, propionic acid, butyric acid, etc.), a dicarboxylic acid (oxalic acid, malonic acid, succinic acid, gluconic acid, adipic acid, fumaric acid, maleic acid, etc.), a tricarboxylic acid (aconitic acid, etc.), a hydroxycarboxylic acid (citric acid, lactic acid, malic acid), an aromatic carboxylic acid (benzoic acid, phthalic acid, salicylic acid, etc.), an oxocarboxylic acid (pyruvic acid, etc.), and an amino acid (arginine, asparagine, aspartic acid, cysteine, glutamic acid, glycine, etc.).

The carboxylic acid or a salt thereof is preferably used in a total content of 0.5 g/L or more and 5 g/L or less, and more preferably 0.8 g/L or more and 2 g/L or less in view of the stability of the solution. In the reductive electroless nickel strike plating solution in the present embodiment, the content of the carboxylic acid or a salt thereof is set to a low level. If the content of the carboxylic acid or a salt thereof is less than 0.5 g/L, it does not function as a complexing agent sufficiently, depending on the type thereof, and thus the nickel ion in the reductive electroless nickel strike plating solution does not become a stable complex so that precipitation of nickel may occur, which is not preferable. On the other hand, the content of the carboxylic acid or a salt thereof is more than 5 g/L, no particular effect cannot obtained and it is a waste of material, which is not preferable.

### Reducing agent:

The reductive electroless nickel strike plating solution includes one or more reducing agents selected from the group consisting of dimethylamine borane, trimethylamine borane, and sodium borohydride. Since any of these substance is used as a reducing agent, the reductive electroless nickel strike plating solution according to the present invention can achieve deposition of nickel on the surface of the copper material without providing any palladium catalyst.

The reducing agent is preferably used in an amount of 2 g/L or more and 10 g/L or less, and more preferably 4 g/L or more and 8 g/L or less. If the content of the reducing agent is less than 2 g/L, a sufficient reductive effect may not be obtained and thus deposition of nickel on the surface of the copper may not proceed, which is not preferable. If the content of the reducing agent is more than 10 g/L, nickel may deposit on the surface of a portion other than the copper, such as the insulating substrate (the selectivity of the deposition on the circuit is impaired), and the decomposition of the reductive electroless nickel strike plating solution may occur to impair the stability of the concentration, which are not preferable.

The reductive electroless nickel strike plating solution is prepared by mixing the above-described components with water and stirring to dissolve them, and is more preferably prepared by mixing the above-described water-soluble nickel salt and carboxylic acid or a salt thereof with water and stirring the resultant to prepare an aqueous solution including a nickel complex and then mixing the above-described reducing agent with the aqueous solution and stirring the resultant. In the reductive electroless nickel strike plating solution thus prepared, the nickel complex can be present stably for a long period of time and excellent stability of the solution can thus be obtained.

The reductive electroless nickel strike plating solution may include components such as a sulfate salt, boric acid, and a chloride salt, in addition to the above-described components.

### pH:

The reductive electroless nickel strike plating solution is preferably adjusted to a pH within a neutral range of 6.0 or more and 10.0 or less. If the pH is less than 6, the deposition rate of nickel is low to result in less ability of deposition of the nickel plating film 13, and thus failure in deposition, such as a pore or a recess (a hole), may be caused in the surface of the nickel plating film, which is not preferable. On the other hand, if the pH is more than 10, the deposition rate of nickel is so high that the control of the film thickness of the nickel plating film 13 may be difficult or that the dense crystal form of nickel deposited cannot be achieved, which is not preferable.

### Bath temperature:

The reductive electroless nickel strike plating solution is preferably adjusted to a bath temperature of 20°C or more and 55°C or less. If the bath temperature is less than 20°C, the deposition rate of nickel is low to result in less productivity of the nickel plating film 13, and thus a pore or a recess (a hole) may be caused on the surface of the nickel plating film 13, or no deposition of nickel is caused, which is not preferable. On the other hand, if the bath temperature is more than 55°C, the stability of the electroless nickel strike plating solution is impaired and the lifespan of the solution becomes thus short, which are not preferable.

### 1-4-2. Characteristics of reductive electroless nickel strike plating step (S4)

In the reductive electroless nickel strike plating step (S4) in the present embodiment, one or more substance selected from the group consisting of dimethylamine borane, trimethylamine borane, and sodium borohydride, which are included in the reductive electroless nickel strike plating solution, function as a reducing agents, and accordingly, nickel including boron can be deposited on the surface of the copper material without providing any palladium catalyst. In this method, any palladium catalyst is not provided, and accordingly, there is no unnecessary deposition of nickel due to a palladium residue remaining in an insulated region between wiring patterns. This method thus enables nickel plating on fine wiring patterns.

Since the reductive electroless nickel strike plating solution has a small nickel content and also has a pH adjusted to 6.0 or more and 10.0 or less and a bath temperature adjusted to 20°C or more and 55°C or less, the deposition rate of nickel is appropriate and the nickel plating film 13 can be directly produced on the surface of the copper material by the reductive electroless nickel strike plating method. At this time, nickel is allowed to uniformly deposit on the surface of the copper material since the deposition rate of nickel is appropriate. As a result, the film thickness is uniform, and thus the nickel plating film 13 surely coating the surface of the copper material can be produced even when the film thickness is thin. The nickel plating film 13 obtained is excellent in the barrier properties of preventing the diffusion of copper, compared to a nickel plating film obtained by a conventional electroless plating process.

In the reductive electroless nickel strike plating step (S4), the reductive electroless nickel strike plating solution can be prevented from decomposing since the reductive electroless nickel strike plating solution has a content of the water-soluble nickel salt (in terms of nickel) as small as 0.002 g/L or more and 1 g/L or less. In addition, since the reductive electroless nickel strike plating solution includes no stabilizer such as a lead salt or a bismuth salt, a nickel plating film including no heavy metal such as lead or bismuth can be obtained.

### 1-5. Reductive electroless gold plating step (S5) in embodiment

For the reductive electroless gold plating step (S5) in the present embodiment, a reductive electroless gold plating method is used. In the reductive electroless gold plating method, a reductive electroless gold plating solution is used that includes a water-soluble gold compound, citric acid or a salt of citric acid, ethylenediaminetetraacetic acid or a salt of ethylenediaminetetraacetic acid, hexamethylenetetramine, and "a chain polyamine including an alkyl group having 3 or more carbon atoms and 3 or more amino groups", and has a pH adjusted to 7.0 or more and 9.0 or less and a bath temperature adjusted to 40°C or more and 90°C or less, and the copper material on which the nickel plating film 13 has been formed by the electroless nickel strike plating method is immersed in the reductive electroless gold plating solution to thereby produce a gold plating film 14. If a displacement electroless plating method is used here, nickel may dissolve to generate a through-hole in the nickel plating film, and accordingly, any displacement electroless plating method is not used.

### 1-5-1. Reductive electroless gold plating solution

The reductive electroless gold plating solution in the present embodiment is used for forming a gold plating film 14 on the surface of an object to be plated, and includes a water-soluble gold compound, citric acid or a salt of citric acid, ethylenediaminetetraacetic acid or a salt of ethylenediaminetetraacetic acid, hexamethylenetetramine, and a chain polyamine including an alkyl group having 3 or more carbon atoms and 3 or more amino groups.

### Water-soluble gold compound:

The water-soluble gold compound used for the reductive electroless gold plating solution in the present embodiment may be any of water-soluble gold compound from a gold cyanide salt and a non-cyanide gold salt, as long as it is soluble in the plating solution to obtain a predetermined concentration. Specific examples of the water-soluble gold compound of the gold cyanide salt include potassium gold cyanide, sodium gold cyanide, and ammonium gold cyanide. Specific examples of the water-soluble gold compound of the non-cyanide gold salt include chloroaurate, gold sulfite salt, and gold thiosulfuric acid salt. Among these, potassium gold cyanide is particularly preferred. The water-soluble gold compounds may be used singly or in combinations of two or more thereof. The water-soluble gold compound is not limited to the gold compound listed here.

The concentration of the water-soluble gold compound in the reductive electroless gold plating solution in the present embodiment is preferably 0.0025 mol/L or more and 0.0075 mol/L or less. If the concentration of the water-soluble gold compound is less than 0.0025 mol/L, the deposition rate of gold is low, and it is thus difficult to obtain a gold plating film 14 having a desirable film thickness. If the concentration of the water-soluble gold compound is more than 0.0075 mol/L, the stability of the plating solution may be decreased, and such a concentration is also economically disadvantageous.

### Citric acid or salt of citric acid:

The reductive electroless gold plating solution in the present embodiment contains citric acid or a salt of citric acid. The citric acid or the salt of citric acid is used as a complexing agent that is capable of forming a complex with gold ions. The concentration of the citric acid or the salt of citric acid in the reductive electroless gold plating solution according to the present invention is preferably 0.05 mol/L or more and 0.15 mol/L or less. If the concentration of the citric acid or the salt of citric acid used as a complexing agent is less than 0.05 mol/L, gold precipitates in the plating solution, resulting in poor stability of the solution. If the concentration of the citric acid or the salt of citric acid is more than 0.15 mol/L, the formation of the complex proceeds excessively, resulting in the decrease in the deposition rate of gold, and it is thus difficult to obtain the gold plating film 14 having a desirable film thickness.

### Ethylenediaminetetraacetic acid (EDTA) or a salt of ethylenediaminetetraacetic acid:

The reductive electroless gold plating solution in the present embodiment contains ethylenediaminetetraacetic acid (EDTA) or a salt of ethylenediaminetetraacetic acid. The ethylenediaminetetraacetic acid or the salt of ethylenediaminetetraacetic acid is a complexing agent used in combination with the citric acid or the salt of citric acid described above. The concentration of the ethylenediaminetetraacetic acid or the salt of ethylenediaminetetraacetic acid in the reductive electroless gold plating solution is preferably 0.03 mol/L or more and 0.1 mol/L or less. If the concentration of the ethylenediaminetetraacetic acid or the salt of ethylenediaminetetraacetic acid used as a complexing agent is less than 0.03 mol/L, gold precipitates in the plating solution, resulting in poor stability of the solution. If the concentration of the ethylenediaminetetraacetic acid or the salt of ethylenediaminetetraacetic acid is more than 0.1 mol/L, the formation of the complex proceeds excessively, resulting in the decrease in the deposition rate of gold, and it is thus difficult to obtain the gold plating film 14 having a desirable film thickness.

### Hexamethylenetetramine:

The reductive electroless gold plating solution in the present embodiment contains hexamethylenetetramine. The hexamethylenetetramine reduces gold ions in the plating solution, and is thus used as a reducing agent for depositing gold on the surface of an object to be plated.

The concentration of hexamethylenetetramine in the reductive electroless gold plating solution in the present embodiment is preferably 0.003 mol/L or more and 0.009 mol/L or less. If the hexamethylenetetramine concentration is less than 0.003 mol/L, the deposition rate of gold is low, and it is thus difficult to obtain the gold plating film 14 having a desirable film thickness. If the hexamethylenetetramine concentration is more than 0.009 mol/L, the reduction reaction may proceed quickly to abnormally precipitate the gold salt in the plating solution, resulting in poor stability of the solution, and such a concentration is also economically disadvantageous.

### Chain polyamine:

The reductive electroless gold plating solution in the present embodiment contains a chain polyamine including an alkyl group having 3 or more carbon atoms and 3 or more amino groups. The chain polyamine is an amine compound that serves as a reducing auxiliary agent for helping the reduction of the gold ions in the plating solution. Specifically, 3,3'-diamino-N-methyldipropylamine or N,N'-bis(3-aminopropyl)ethylenediamine is preferable as the chain polyamine. These are preferable in view of, particularly, the properties of the plating film to be obtained and also from an economical viewpoint.

The concentration of the chain polyamine in the reductive electroless gold plating solution in the present embodiment is preferably 0.02 mol/L or more and 0.06 mol/L or less. When the chain polyamine concentration is within the range of 0.02 mol/L or more and 0.06 mol/L or less, a high deposition rate can be maintained without affecting the film thickness of the underlying metal film. In addition, since the throwing power of the gold plating film 14 can be improved, the gold plating film 14 with a thickness of 0.2 µm or more can be obtained. Furthermore, the stability of the solution can be significantly improved.

### Other components:

The reductive electroless gold plating solution in the present embodiment may contain a deposition promoter, in addition to the water-soluble gold compound, the citric acid or the salt of citric acid, ethylenediaminetetraacetic acid or the salt of ethylenediaminetetraacetic acid, hexamethylenetetramine, and the chain polyamine including an alkyl group having 3 or more carbon atoms and 3 or more amino groups described above. Examples of the deposition promoter used here include a thallium compound and a lead compound. The thallium compound is preferably used in view of thickening the gold plating film to be obtained.

The concentration of the thallium compound as a deposition promoter in the reductive electroless gold plating solution in the present embodiment is preferably 1 mg/L or more and 10 mg/L or less. If the concentration of the thallium compound as a deposition promoter is less than 1 mg/L, it is difficult to thicken the gold plating film 14. Even if the concentration of the thallium compound as a deposition promoter is more than 10 mg/L, more thickening cannot be achieved, which is economically disadvantageous.

The reductive electroless gold plating solution in the present embodiment may contain an additives such as a pH adjuster, an antioxidant, a surfactant, and a brightener, in addition to the essential components described above.

Examples of the pH adjuster include, but not particularly limited to, potassium hydroxide, sodium hydroxide, aqueous ammonia solution, sulfuric acid, and phosphoric acid. The reductive electroless gold plating solution in the present embodiment is preferable kept at a pH of 7.0 or more and 9.0 or less by using the pH adjuster. If the pH of the reductive electroless gold plating solution is lower than 7.0, the plating solution is likely to decompose. If the pH is higher than 9.0, the plating solution is so stable that the deposition rate of the plating is low, and it takes much time to thicken the gold plating film. Furthermore, adjusting the pH condition to 7.0 or more and 9.0 or less enables plating treatment of an object to be plated that is made a material sensitive to alkali. As the additives including the antioxidant, the surfactant, and the brightener, known substances may be used.

### 1-5-2. Conditions for plating

The conditions of gold plating with the reductive electroless gold plating solution in the present embodiment is not particularly limited; however, the solution temperature is preferably 40°C or more and 90°C or less, and particularly preferably 75°C or more and 85°C or less in view of the deposition rate of gold and the stability of the solution. The plating time is also not particularly limited, and is preferably 1 minute or more and 2 hours or less and particularly preferably 2 minutes or more and 1 hours or less.

### 1-5-3. reductive electroless gold plating method

Next, the reductive electroless gold plating method in the present embodiment will be described. In the reductive electroless gold plating method in the present embodiment, electroless gold plating treatment is carried out on the surface of an object to be plated with any of the reductive electroless gold plating solution described above to thereby form the gold plating film 14. In the reductive electroless gold plating method, plating treatment is carried out by immersing the object to be plated in the electroless gold plating solution, as in a common treatment process of reductive electroless plating.

In the electroless gold plating method according to the present invention, any of copper, gold, and nickel is preferably present on the surface of the object to be plated, which is the target of the process. When any of copper, gold, and nickel is present on the surface of the object to be plated, it may be present in any form. Particularly, it is more preferable to use an object to be plated itself made of copper, or an object to be plated having any film made of copper, gold, nickel or an alloy containing any of these metals on the surface thereof. Examples of the alloy containing any of these metals include gold-cobalt. Gold, nickel, copper, or an alloy containing any of these metals serves as an underlying metal for the electroless gold plating in the present invention, and the metal or alloy exhibits the effect of a catalytic activity on hexamethylenetetramine as a reducing agent included in the reductive electroless gold plating solution described above.

### 1-5-4. Characteristics of reductive electroless gold plating step (S5)

In the reductive electroless gold plating step (S5) in the present embodiment, since the reductive electroless gold plating method is used, elution of nickel from the nickel plating film 13 can be prevented without providing a palladium plating film, when the gold plating film 14 is formed. The reductive electroless gold plating solution in the present embodiment has good deposition selectivity since it causes the reaction for deposition of gold only on the surface of gold, nickel, or copper, which can serve as a catalytic nucleus, and not on a region without any catalytic nucleus. Accordingly, formation of the gold plating film can be avoided on an area where deposition of gold is unnecessary.

### 1-6. Characteristics of electroless plating process of present embodiment

In the electroless plating process of the present embodiment, a nickel plating film can be formed by the reductive electroless nickel strike plating step (S4) directly on the surface of the copper material without providing any palladium catalyst. In addition, the surface of the copper material can be certainly coated even when the film thickness is thin, and also, the nickel plating film 13 excellent in the barrier properties against to the copper material can be formed since the nickel includes boron. Thus, thinning the nickel plating film can be achieved. Accordingly, a two-layer plating film can be formed with an excellent deposition selectivity without providing any palladium catalyst even on fine wirings.

In addition, a two-layer plating film having a thin film thickness as a whole can be obtained since the film thickness of the nickel plating film 13 can be thin. Also, the reductive electroless nickel strike plating step (S4) can give the nickel plating film 13 having a uniform film thickness with excellent smoothness, and accordingly, a gold plating film 14 having a uniform film thickness can be produced thereon, resulting in a two-layer plating film with small variation in the film thickness. Furthermore, the nickel plating film formed by the electroless strike plating method is excellent in the adhesion to the copper material and also excellent in the barrier properties of preventing diffusion of copper, and accordingly, a two-layer plating film having the excellent mounting properties can be formed. Owing to having the characteristics described above, a wiring pattern on a printed wiring board can be obtained that is excellent in all of the wettability with solder, the solder ball-mounting property, and the wire bonding property.

Furthermore, since the gold plating film 14 is produced on the surface of the nickel plating film 13 by the reductive electroless gold plating method without providing any palladium plating film in the reductive electroless gold plating step (S5), the phenomenon of local corrosion of nickel does not occur even if the nickel plating film 13 has a film thickness of 0.1 µm or less.

### 1-7. Finishing in electroless plating process of present embodiment

After completing the reductive electroless gold plating step (S5) described above, washing can be carried out, followed by drying. By carrying out the electroless plating process shown in Figure 2 as described above, a two-layer plating film can be formed on the surface of the copper material.

### 2. Embodiment of two-layer plating film according to present invention

Preferably, the two-layer plating film according to the present invention is a two-layer plating film formed by the electroless plating process described hereinabove, and is a two-layer plating film consisting of a nickel plating film containing boron and a gold plating film. Embodiments of the two-layer plating film will be described below.

### 2-1. Structure of two-layer plating film

A schematic cross-sectional view of the two-layer plating film of the present embodiment is shown in Figure 2. A substrate 11 is not particularly limited as long as it is for mounting electronic components and allows the formation of a wiring pattern. Examples of a rigid substrate include a paper phenol substrate, a paper epoxy substrate, a glass composite substrate, a glass epoxy substrate, a fluororesin substrate, and a ceramic substrate. As a flexible substrate, a thin film of polyimide, polyester, or the like can be used.

For the formation of the wiring pattern, there are various methods, including a method in which unnecessary parts of copper foil is removed from a substrate with copper foil attached to the whole surface thereof to thereby allow a wiring pattern to remain, and a method in which a wiring pattern is added afterward to a substrate. The means to form the copper wiring 12 in the present embodiment is not limited. An exemplary method involves photolithography, in which copper wiring is formed in the following manner. A resist material applied to the whole surface of copper foil on a substrate 11 is irradiated with ultraviolet radiation via a film for exposure, and the resist in the region that has not been irradiated with ultraviolet radiation is removed, for example, with a solvent to thereby form a resist pattern on the copper foil that is to remain as a wiring pattern. Then, the copper foil in the region where the resist pattern has not been formed is removed by etching to thereby form a copper wiring 12.

In the case where the copper wiring 12 formed as described above is a pattern for mounting thereon electronic components and terminal components to be connected by solder-mounting or bonding and the like, the two-layer plating film of the present embodiment include a nickel plating film 13 and a gold plating film 14 provided in this order on the surface of the copper wiring 12.

The film thickness of the nickel plating film 13 is preferably 0.005 µm or more and 0.05 µm or less. If the film thickness of the nickel plating film 13 is less than 0.005 µm, the mounting properties with solder and the wire bonding properties are decreased, which is not preferable. If the film thickness of the nickel plating film 13 is more than 0.05 µm, the deposition of nickel occurs between copper wires, which is not preferable.

The film thickness of the gold plating film 14 is preferably 0.01 µm or more. If the film thickness of the gold plating film 14 is less than 0.01 µm, nickel in the nickel plating film diffuses to the gold plating film, which is not preferable.

### 2-2. Characteristics of two-layer plating film

In the two-layer plating film of the present embodiment, the nickel plating film 13 includes boron. Since boron is contained in the nickel plating film 13, the diffusion of copper in the copper wiring 12 to the gold plating film 14 side is suppressed. The boron content of the nickel plating film 13 is preferably 0.01 mass% or more and 0.1 mass% or less. If the boron content is less than 0.01 mass%, the diffusion of copper in the copper wiring 12 to the gold plating film 14 side cannot be sufficiently prevented. If the copper diffuses to the gold plating film 14 side, the wettability with solder, the solder ball-mounting property, and the wire bonding property are impaired. If the boron content is more than 0.1 mass%, the abnormal precipitate of nickel in the plating solution or the decomposition of the nickel plating solution occurs, and the formation of a plating film is thus difficult.

The two-layer plating film of the present embodiment, which includes boron in the nickel plating film 13 as described above, suppresses the diffusion of copper to the gold plating film and is excellent in all of the wettability with solder, the solder ball-mounting property, and the wire bonding property without thickening the film thickness of the gold plating film.

The embodiments of the present invention described hereinabove are modes of the present invention, and can be appropriately changed without departing from the spirit of the present invention. The present invention will now be more specifically described by way of examples, but the present invention is not limited to the examples below.

### Examples

In the electroless plating process of this example, steps S1 to S5 shown in Figure 1 were carried out in the present order to thereby formig a nickel plating film and a gold plating film in this order on the surface of a copper material. First, the degreasing step (S1), the etching step (S2), and the desmutting step (S3) described hereinabove were carried out in this order, and then the reductive electroless nickel strike plating step (S4) was carried out.

In the reductive electroless nickel strike plating step (S4), a copper material was immersed in the reductive electroless nickel strike plating solution of the formulation described below to form a nickel plating film on the surface of the copper material. The reductive electroless nickel strike plating solution was prepared in the following manner: nickel sulphate hexahydrate, DL-malic acid, and water were mixed and stirred to thereby prepare an aqueous solution including a nickel complex, and dimethylamine borane was then added thereto, followed by stirring. While the copper material was immersed in the electroless nickel strike plating solution, the electroless nickel strike plating solution was stirred by aeration.

| | |
|---|---|
| Nickel sulphate hexahydrate | 0.2 g/L (0.045/L in terms of nickel) |
| DL-malic acid | 1.0 g/L |
| Dimethylamine borane | 4.0 g/L |
| pH | 9.0 |
| Bath temperature | 50°C |

Then, the reductive electroless gold plating step (S5) was carried out. The copper material having the nickel plating film formed thereon was immersed in the reductive electroless gold plating solution of the formulation described below to form a gold plating film on the surface of the nickel plating film. In the way described above, a two-layer plating film consisting of a nickel plating film containing boron and a gold plating film was formed on the surface of a copper material.

| | |
|---|---|
| Potassium gold cyanide | 5 mmol/L |
| Dipotassium ethylenediaminetetraacetate | 0.03 mol/L |
| Citric acid | 0.15 mol/L |
| Hexamethylenetetramine | 3 mmol/L |
| 3,3'-Diamino-N-methyldipropylamine | 0.02 mol/L |
| Thallium acetate | 5 mg/L |
| pH | 8.5 |
| Bath temperature | 80°C |

### Comparative Examples

### [Comparative Example 1]

In the electroless plating process in Comparative Example 1, a gold plating film was formed on the surface of a copper material by carrying out the same the electroless plating process as of Examples, except that the electroless nickel strike plating step (S4) was not carried out.

### [Comparative Examples 2 and 3]

In the electroless plating process of Comparative Examples 2 and 3, treatment for providing a palladium catalyst and electroless nickel plating, which were carried out in the electroless plating process of the prior art, were carried out instead of the electroless nickel strike plating step (S4). Subsequently, a displacement gold plating film and a reductive gold plating film were formed in this order.

In the treatment for providing a palladium catalyst, a desmutted copper material was immersed in a palladium catalyst solution including a palladium compound in an amount of 30 mg/L in terms of palladium and sulfate ions, to thereby provide a palladium catalyst on the surface of the copper material.

In the electroless nickel plating, the copper material provided with the palladium catalyst was immersed in a electroless nickel plating solution of the formulation described below.

| | |
|---|---|
| Nickel sulphate hexahydrate | 22.4 g/L (5 g/L in terms of nickel) |
| DL-malic acid | 15 g/L |
| Lactic acid | 18 g/L |
| Sodium hypophosphite | 30 g/L |
| pH | 4.5 |
| Bath temperature | 80°C |

In the subsequent displacement gold plating, the copper material having the nickel plating film formed thereon was immersed in the displacement gold plating solution of the formulation described below to form a displacement gold plating film on the surface of the nickel plating film.

| | |
|---|---|
| Potassium gold cyanide | 0.01 mol/L |
| Ethylenediaminetetraacetic acid | 0.03 mol/L |
| Citric acid | 0.15 mol/L |
| Thallium acetate | 50 mg/L |
| pH | 4.5 |
| Bath temperature | 80°C |

The subsequent reductive gold plating was carried out in the same manner as described in Examples.

### [Comparative Example 4]

The electroless plating process of Comparative Example 4 was carried out in the same manner as in Comparative Examples 2 and 3, except that the reductive gold plating was not carried out.

The film thickness of each of the plating films formed in Example and Comparative Examples 1 to 4 are shown in Table 1.

**[Table 1]**

| | Nickel plating film | Displacement gold plating film | Reductive gold plating film |
|---|---|---|---|
| Example | 0.01 µm | - | 0.1 µm |
| Comparative Example 1 | - | - | 0.1 µm |
| Comparative Example 2 | 5 µm | 0.05 µm | 0.05 µm |
| Comparative Example 3 | 5 µm | 0.05 µm | 0.2 µm |
| Comparative Example 4 | 5 µm | 0.1 µm | - |

### [Evaluation]

### 1. Local corrosion of nickel plating film

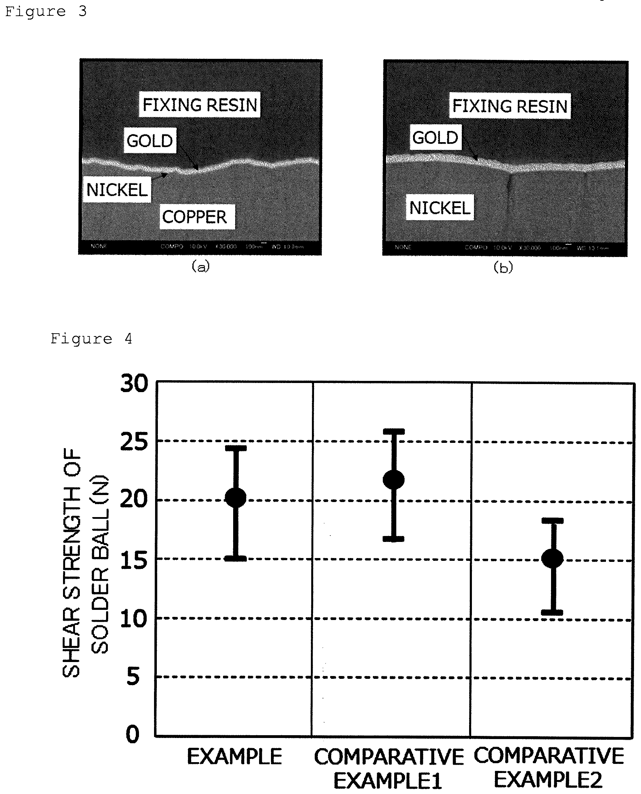

Figure 3 shows images of the cross-section of the interface moiety between the nickel plating film and the gold plating film in Example and Comparative Example 2, the images taken by a scanning electron microscopy (SEM) at a magnification of 30000x. Figure 3(a) shows the image of the cross-section in Example. Between the copper material and the gold plating film, provided was a nickel plating film that was so thin (0.01 µm) that it is difficult to visibly find in Figure 3(a). It was confirmed from the image that the plating film was favorable without local corrosion of the nickel plating film. On the other hand, Figure 3(b) shows the image of the cross-section in Comparative Example 2. It was confirmed from this that local corrosion, which is observed as a black image in the form of a streak, occurred in the nickel plating film. It was confirmed from the above that the electroless plating process of Example was a plating process that enables formation of a plating film of good quality in which the occurrence of local corrosion of a nickel plating film was suppressed.

### 2. Shear strength of solder ball

Soldering was carried out on the surface of each of the plating films of Example and Comparative Examples 1 and 2, and then the shear strength of the solder ball was measured. The shear strength of the solder ball was measured for a shear height of 20 µm at a shear speed of 500 µm/second using a shear tester for solder ball (series 4000) manufactured by DAGE, and the maximum, minimum and average thereof were determined. The results are shown in Figure 4.

It was confirmed from Figure 4 that the two-layer plating film produced by the electroless plating process of Example had an excellent shear strength of solder ball. This was achieved without thickening the gold plating film because of the following: the occurrence of local corrosion of the nickel plating film is suppressed as described above, and diffusion of copper to the gold plating film is suppressed by boron contained in the nickel plating film. Then, it was also confirmed that the plating film in Comparative Example 1, which had only a reductive gold plating film produced on the surface of a copper material, had a shear strength of solder ball similar to that in Example. On the other hand, it was confirmed that the shear strength of solder ball was poor in Comparative Example 2 because local corrosion of the nickel plating film occurred.

### 3. Breaking mode of solder ball

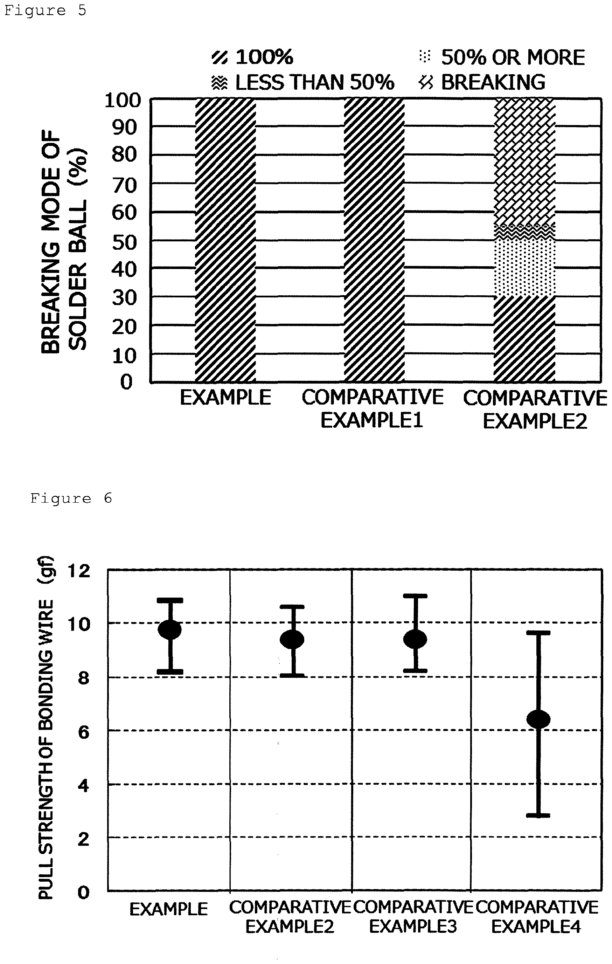

Figure 5 shows the confirmation results of the breaking mode of the solder ball when the shear strength of solder ball was measured. "100%" means a state in which 100% of the solder remains on the plating film on the copper wiring. "50% or More" means a state in which 50% or more of the solder remains on the plating film on the copper wiring. "Less Than 50%" means a state in which less than 50% of the solder remains on the plating film on the copper wiring. "Breaking" means a interfacial failure state in which no solder remains on the plating film on the copper wiring. In Example and Comparative Example 1, in which a favorable shear strength of solder ball was exhibited, the breakage occurs in the solder, and found is a state in which 100% of the solder remains on the plating film. In other words, it was confirmed that the failure does not reach the plating film and that the plating film is thus firm.

In Comparative Example 2, in which the shear strength of solder ball was poor, the ratio of the solder remained in an amount of 50% or more was 20%, the ratio of the solder remained in an amount less than 50% was 5%, and the ratio of breaking was 45%. It was thus confirmed that local corrosion of the nickel plating film occurred to thereby allow copper and nickel to diffuse to the gold plating film, and that the diffused copper and nickel oxidized to thereby deteriorate the wettability with the solder.

### 4. Pull strength of bonding wire

In Example and Comparative examples 2 to 4, a gold wire having a wire diameter of 25 µm was joined to the surface of each plating film, and then the joining strength, i.e., the wire bonding strength, was measured when the gold wire was pulled by a pull tester. The maximum, minimum and average thereof were determined. The measurement results are shown in Figure 6. It was confirmed that the pull strength of the bonding wire in Example is comparable to that in Comparative examples 2 and 3, which were each a conventional electroless plating process. It was also confirmed in Comparative Example 4 that the average of the pull strength of the bonding wire was small and also that the variation was large. This is because the wire bonding property is deteriorated by the effect of the diffusion of copper and nickel to the gold plating film due to local corrosion of the nickel plating film when only a displacement gold plating film is included.

From the above-described measurement results of the shear strength of the solder ball and the pull strength of the bonding wire and the confirmation results of the breaking mode of the solder ball, it was confirmed that the two-layer plating film formed by the electroless plating process of Example had the excellent various mounting properties with solder and the excellent wire bonding property.

In other words, the electroless plating process according to the present invention can form a nickel plating film directly on a copper material without providing a palladium catalyst and thus enables plating on a fine wiring pattern. Furthermore, a gold plating film can be formed on the surface of the nickel plating film by the reductive electroless gold plating method without providing a palladium plating film, which enables formation of a plating film at a reduced cost.

The two-layer plating film according to the present invention is a two-layer plating film consisting of a nickel plating film including boron and a gold plating film. Since the two-layer plating film according to the present invention includes boron in the nickel plating film, diffusion of copper to the gold plating film is suppressed, and the two-layer plating film thus has the excellent various mounting properties with solder and the excellent wire bonding property without thickening the film thickness of the gold plating film.

### Industrial Applicability

The electroless plating process according to the present invention enables plating on a fine wiring pattern and can provide a two-layer plating film consisting of a nickel plating film and a gold plating film, the two-layer plating film being excellent in all of the wettability with solder, the solder ball-mounting property, and the wire bonding property. Accordingly, the electroless plating process is suitable for printed wiring boards on which high-density mounting is needed due to downsizing of electronic components mounted.

### Reference Signs List

- 11: substrate
- 12: copper wiring
- 13: nickel plating film
- 14: gold plating film

## Claims

1. A electroless plating process for forming a nickel plating film and a gold plating film in this order on a surface of a copper material by a electroless plating method, the electroless plating process comprising:
a step of forming a nickel plating film containing boron by a reductive electroless nickel strike plating method, and
a step of forming a gold plating film by a reductive electroless gold plating method.

2. The electroless plating process according to claim 1, wherein in the reductive electroless nickel strike plating method, a reductive electroless nickel strike plating solution is used that comprises one or more reducing agents selected from the group consisting of dimethylamine borane, trimethylamine borane, and sodium borohydride and has a reducing agent content of 2 g/L or more and 10 g/L or less.

3. The electroless plating process according to claim 1 or 2, wherein in the reductive electroless gold plating method, a reductive electroless gold plating solution is used that comprises a water-soluble gold compound, citric acid or a salt of citric acid, ethylenediaminetetraacetic acid or a salt of ethylenediaminetetraacetic acid, hexamethylenetetramine, and a chain polyamine including an alkyl group having 3 or more carbon atoms and 3 or more amino groups.

4. A two-layer plating film formed by the electroless plating process according to any one of claims 1 to 3, consisting of a nickel plating film containing boron and a gold plating film.

5. The two-layer plating film according to claim 4, wherein the nickel plating film has a boron content of 0.01 mass% or more and 0.1 mass% or less.

6. The two-layer plating film according to claim 4 or 5, wherein the nickel plating film has a film thickness of 0.005 µm or more and 0.05 µm or less.

7. The two-layer plating film according to any one of claims 4 to 6, wherein the gold plating film has a film thickness of 0.01 µm or more.
